# EUROPÄISCHE PATENTANMELDUNG

(11) **EP 0 969 474 A1**
(43) Veröffentlichungstag der Anmeldung: **05.01.2000**
(21) Anmeldenummer: 99112470.2
(22) Anmeldetag: 30.06.1999
(51) Int. Cl.: G11C 7/00

(54) **Dynamische Halbleiter-Speichervorrichtung und Verfahren zur Initialisierung einer dynamischen Halbleiter-Speichervorrichtung**

(30) Priorität: 30.06.1998 DE 19829288
(71) Anmelder: SIEMENS AKTIENGESELLSCHAFT, 80333 München (DE)
(72) Erfinder: Buck, Martin, 81243 München (DE); Fischer, Helmut, Dr., 82024 Taufkirchen (DE); Hemmert, Heinrich, 81549 München (DE); Kuhne, Sebastian, 81249 München (DE); Johnson, Bret, 81737 München (DE)

(57) **Zusammenfassung**

Die Erfindung betrifft eine dynamische Halbleiter-Speichervorrichtung vom wahlweisen Zugriffstyp (DRAM/SDRAM) mit einer den Einschaltvorgang der Halbleiter-Speichervorrichtung und ihrer Schaltungsbestandteile steuernden Initialisierungsschaltung, welche nach einer nach dem Einschalten der Halbleiter-Speichervorrichtung erfolgten Stabilisierung der Versorgungsspannung ein Versorgungsspannungsstabilsignal (POWERON) liefert. Die Initialisierungsschaltung weist eine Vorausdetektorschaltung (RCV2) auf, die einen vorbestimmten Pegelzustand eines von außen anliegenden Takt-Steuersignales (CKE) zeitlich vor dem Versorgungsspannungsstabilsignal (POWERON) erfasst und als Reaktion hierauf ein erstes Freigabesignal zur Entriegelung der zum ordnungsgemäßen Betrieb der Halbleiter-Speichervorrichtung vorgesehenen Steuerschaltung (6) liefert.

## Beschreibung

Die Erfindung betrifft eine dynamische Halbleiter-Speichervorrichtung vom wahlweisen Zugriffstyp (DRAM/SDRAM) mit einer den Einschaltvorgang der Halbleiter-Speichervorrichtung und ihrer Schaltungsbestandteile steuernden Initialisierungsschaltung, welche nach einer nach dem Einschalten der Halbleiter-Speichervorrichtung erfolgten Stabilisierung der Versorgungsspannung ein Versorgungssspannungsstabilsignal (POWERON) liefert, ein Verfahren zur Initialisierung einer solchen dynamischen Halbleiter-Speichervorrichtung, sowie die Verwendung einer ein Freigabesignal liefernden Freigabeschaltung zur Steuerung des Einschaltvorganges einer dynamischen Halbleiter-Speichervorrichtung.

Bei SDRAM-Halbleiterspeichern nach dem JEDEC-Standard ist während des Einschaltvorganges ("POWERUP") dafür zu sorgen, dass die internen, für den ordnungsgemäßen Betrieb der Halbleiter-Speichervorrichtung vorgesehenen Steuerschaltungen sicher in einem definierten Sollzustand gehalten werden, um eine unerwünschte Aktivierung von Ausgangstransistoren zu verhindern, die auf den Datenleitungen einen Kurzschluss (sogenannte "Bus Contention" bzw. "Data Contention") oder eine unkontrollierte Aktivierung von internen Stromverbrauchern hervorrufen würde. Aufgrund einer prinzipiellen Unvorhersehbarkeit des zeitlichen Verlaufes der Versorgungsspannung und des bzw. der Spannungspegel an den externen Steuereingängen während des Einschaltvorganges des Halbleiter-Speichers gestaltet sich die Lösung dieses Problems schwierig. Nach den Herstellerspezifikationen sollte ein SDRAM-Bauelement sämtliche Befehle, die zeitlich vor einer definierten Initialisierungsabfolge anliegen, ignorieren. Diese Abfolge besteht aus vorbestimmten Kommandos, die in einer definierten zeitlichen Reihenfolge angelegt werden müssen. Eine Reihe von Funktionen und Kommandos, die im ordnungsgemäßen Betrieb des Bauelementes erlaubt sind, sind jedoch zeitlich erst nach der Initialisierungsabfolge erwünscht bzw. erlaubt. Nach dem JEDEC-Standard für SDRAM-Halbleiter-Speicher ist eine empfohlene Initialisierungsabfolge (sogenannte "POWERON-SEQUENCE") wie folgt vorgesehen:
1. Anlegen eines Versorgungsspannungs- und Startimpulses, um das Zustandekommen einer NOP-Bedingung bei den Eingängen des Bauelementes zu erzielen.
2. Aufrechterhaltung einer stabilen Versorgungsspannung, eines stabilen Taktes, und von stabilen NOP-Eingangsbedingungen für eine Mindestzeitdauer von 200 µs.
3. Vorbereitungskommando für die Wortleitungsaktivierung (PRECHARGE) für sämtliche Speicherbänke der Vorrichtung.
4. Aktivierung von zwei oder mehreren Auffrischungskommandos (AUTOREFRESH).
5. Aktivierung des Lade-Konfigurations-Register-Kommandos (MODE-REGISTER-SET) zur Initialisierung des Modusregisters.

Nach dem Erkennen einer solchen definierten Initialisierungsabfolge befindet sich der Speicherbaustein normalerweise in einem sogenannten IDLE-Zustand, d.h. er ist vorgeladen und für den ordnungsgemäßen Betrieb vorbereitet. Bei den bisher bekannt gewordenen SDRAM-Halbleiter-Speicherbausteinen wurden sämtliche Steuerschaltungen des Bauelementes lediglich mit dem POWERON-Signal entriegelt. Dieses Signal POWERON ist aktiv, wenn die internen Versorgungsspannungen die erforderlichen Werte erreicht haben, die zum ordnungsgemäßen Betrieb des Bauelementes erforderlich sind. Danach ist der Baustein in der Lage, Befehle anzuerkennen und auszuführen.

Der Erfindung liegt die Aufgabe zugrunde, eine konstruktiv möglichst einfache Verbesserung der Steuerung des Einschaltvorganges bei dynamischen Halbleiter-Speichervorrichtungen vom wahlweisen Zugriffstyp (DRAM oder SDRAM) anzugeben, mit welcher die Gefahr eines Kurzschlusses der Datenleitungen und/oder einer unkontrollierten Aktivierung von internen Stromverbrauchern wirksam verhindert wird.

Diese Aufgabe wird durch eine dynamische Halbleiter-Speichervorrichtung vom wahlweisen Zugriffstyp nach Anspruch 1, ein Verfahren zur Initialisierung einer solchen Halbleiter-Speichervorrichtung nach Anspruch 16, sowie durch die Verwendung einer ein zweites Freigabesignal (CHIPREADY) liefernden Freigabeschaltung zur Steuerung des Einschaltvorganges einer derartigen Halbleiter-Speichervorrichtung nach Anspruch 20 gelöst.

Erfindungsgemäß ist vorgesehen, dass die Initialisierungsschaltung eine Vorausdetektorschaltung aufweist, die einen vorbestimmten Pegelzustand eines von außen anliegenden Takt-Steuersignales (CKE) zeitlich vor dem Versorgungsspannungsstabilsignal (POWERON) erfasst, um als Reaktion auf einen ersten Regelwechsel (L-H Übergang) ein erstes Freigabesignal zur Entriegelung der zum ordnungsgemäßen Betrieb der Halbleiter-Speichervorrichtung vorgesehenen Steuerschaltung liefert. Insbesondere wird vermittels der erfindungsgemäßen Initialisierungsschaltung der erstmalige Pegelwechsel des Takt-Steuersignales (CKE) auf den logischen HIGH-Zustand, d.h. Aktiv-Zustand detektiert und als Reaktion das erste Freigabesignal ausgegeben. Normalerweise liegt das Takt-Steuersignal (CKE) von Anfang an auf dem logischen Pegelzustand LOW, d.h. Inaktiv-Zustand; durch die Erfindung gelingt eine möglichst frühzeitige Detektion des Pegelwechsels des Takt-Steuersignales (CKE) auf logisch HIGH, wobei dieser Pegelwechsel zusammen mit der Aktivierung des Versorgungsspannungsstabilsignales POWERON von inaktiv auf aktiv (Aktiv-Zustand = logisch "HIGH") und der ordnungsgemäßen Initialisierungssequenz die Auslösung des zweiten Freigabesignales CHIPREADY bewirkt. Damit ist die Vorausdetektorschaltung bereits vor dem Bereitstellen des POWERON-Signales durch andere Schaltungsteile des Halbleiterchips in der Lage, den vorbestimmten Pegel, insbesondere den LOW-Pegel des Takt-Steuersignales (CKE) zu erkennen.

Nach der besonders bevorzugten Ausführung der Erfindung ist unter dem Takt-Steuersignal das bei synchronen DRAM-Speicherbauelementen Signal CKE ("Input-Clock-Enable") zu verstehen, welches bekanntermaßen dazu dient, das CLK-Signal ("Input-Clock" = Master-Clock-Signal) zu aktivieren, wenn CKE = HIGH ist, und zu deaktivieren, wenn CKE = LOW ist. Bekanntlich wird durch eine Deaktivierung des Taktes, d.h. CKE = LOW, der POWERDOWN-Modus, der SELF-REFRESH-Modus oder der SUSPEND-Modus initialisiert.

Das Signal POWERON kennzeichnet in an sich bekannter Weise die Bereitstellung sämtlicher chipinternen Versorgungsspannungen.

Dem Prinzip der Erfindung folgend ist neben der ohnehin in der Initialisierungsschaltung vorgesehenen regulären Empfängerschaltung bzw. SSTL-Receiver-Schaltung, die normalerweise mit einer Referenzspannung betrieben wird, eine zusätzliche CKE-Receiver-Schaltung bzw. Vorausdetektorschaltung vorgesehen, welche unabhängig von einer Referenzspannung betrieben wird und jedenfalls während der POWERUP-Phase des Speicherbauelementes permanent eingeschaltet bleibt. Diese zusätzliche CKE-Receiver-Schaltung ist damit in der Lage, während des Einschaltvorganges der Halbleiter-Speichervorrichtung (POWERUP-Phase) frühzeitig den erstmaligen Übergang nach dem logischen HIGH-Zustand, d.h. Aktiv-Zustand (allgemein: einen vorbestimmten Pegelzutsand) des Takt-Steuersignales CKE zu detektieren, und zwar noch bevor das Versorgungsspannungsstabilsignal POWERON von inaktiv auf aktiv wechselt. Das von der zusätzlichen Vorausdetektorschaltung gelieferte erste Freigabesignal verriegelt mit dem Inaktivzustand des Takt-Steuersignales CKE das zweite Freigabesignal CHIPREADY. Da die von außen an die Halbleiter-Speichervorrichtung anliegenden Kommandosignale (u.a. CS, RAS, CAS, WE) während des Einschaltvorganges (POWERUP) undefiniert sind, wird auf diese Weise verhindert, dass zufällig die Initialisierungsabfolge durchlaufen wird und damit das zweite Freigabesignal CHIPREADY vorzeitig aktiv wird. Im Laufe der POWERUP-Sequenz erreichen die internen Spannungen ihre definierten Schwellwerte und das Versorgungsspannungsstabilsignal POWERON wird aktiv. Wenn das Takt-Steuersignal CKE erstmalig in den aktiven Zustand wechselt, wird die Verriegelung des zweiten Freigabesignals CHIPREADY mit CKE = aktiv und POWERON = aktiv aufgehoben. Dies geschieht nur beim ersten CKE-Übergang auf logisch HIGH, da das erste Freigabesignal auf einen entsprechenden Flip-Flop-Eingang der Freigabeschaltung geht. Danach kann das CKE-Signal bzw. das erste Freigabesignal toggeln, ohne dass ein weiterer Einfluss auf das zweite Freigabesignal CHIPREADY besteht. Die Erkennung dieses ersten CKE-Überganges auf logisch HIGH ist nach einer zweckmäßigen Weiterführung der Erfindung eine der Bedingungen für die Aktivierung des zweiten Freigabesignales CHIPREADY. Die weiteren Bedingungen für die Aktivierung des zweiten Freigabesignals CHIPREADY sind wie bisher in der Initialisierungsabfolge definiert. Das zweite Freigabesignal CHIPREADY wird in die Ausgangspufferkontroll-Logik geleitet und verriegelt dort die OCD-Schaltungen (OCD = Off Chip Driver). Voraussetzung für die Aktivierung des CHIPREADY-Signales ist somit der logische HIGH-Pegel des POWERON-Signales. Ab dem Zeitpunkt, ab dem das POWERON-Signal auf logisch HIGH ist, wird der erste Übergang von LOW auf HIGH, oder der erste HIGH-Pegel des CKE-Signales ausgewertet.

Nach einer vorteilhaften Ausgestaltung der Erfindung wird ein zweites Freigabesignal CHIPREADY generiert, welches in Abhängigkeit weiterer interner Signale und der Initialisierungsabfolge aktiv wird und danach vorbestimmte Schaltungen entriegelt. Bis zur Beendigung der vorgegebenen Initialisierungsabfolge bleiben die vorbestimmten Schaltungen verriegelt. Beispielsweise werden Kommandos decodiert, jedoch nicht ausgeführt, und die Ausgangstreiber hochohmig gehalten.

Nach der bevorzugten Anwendung bei SDRAM-Speichervorrichtungen nach dem JEDEC-Standard (beispielsweise nach dem international geltenden JEDEC-Standard JC-16-97-58A Item Nr. 53 für SDRAM-Speicherbauelemente) ist vorgesehen, dass die von außen an die Halbleiter-Speichervorrichtung angelegten Kommandosignale der von der Freigabeschaltung erkennenden Initialisierungsabfolge das Vorbereitungskommando für die Wortleitungsaktivierung (PRECHARGE), und/oder das Auffrischungskommando (AUTOREFRESH), und/oder das Lade-Konfigurations-Register-Kommando (MODE-REGISTER-SET) aufweist.

Nach einer vorteilhaften konstruktiven Ausgestaltung der erfindungsgemäßen Initialisierungsschaltung ist vorgesehen, dass die Freigabeschaltung bistabile Kippschaltungsstufen mit jeweils einem Setzeingang, an dem ein Kommandosignal (PRECHARGE, AUTOREFRESH, MODE-REGISTER-SET) bzw. das Takt-Steuersignal CKE anliegt, jeweils einem Rücksetzeingang, an dem das Versorgungsspannungsstabilsignal (POWERON) oder ein davon abgeleitetes bzw. verknüpftes Signal anliegt, und mit jeweils einem Ausgang, an dem das Freigabesignal (CHIPREADY) abgeleitet ist, aufweist.

Weitere vorteilhafte Ausgestaltungen der Erfindung ergeben sich aus den Unteransprüchen.

Nachfolgend wird die Erfindung anhand mehrerer in der Zeichnung dargestellter Ausführungsbeispiele weiter erläutert. Es zeigt:
- Figur 1: eine schematische Blockdarstellung von Bestandteilen einer den Einschaltvorgang des Halbleiterspeichers und ihrer Schaltungsbestandteile steuernden Initialisierungsschaltung;
- Figur 2: ein Zeitablaufdiagramm zur Erläuterung der Funktionsweise der Schaltung nach Figur 1;
- Figur 3: eine schematische Blockdarstellung der zum Verständnis der Erfindung wesentlichen Schaltungsbestandteile eines SDRAM-Speichers nach dem JEDEC-Standard;
- Figur 4: ein schematisches Schaltbild einer das zweite Freigabesignal (CHIPREADY) liefernden Freigabeschaltung; und
- Figur 5: ein Zeitablaufdiagramm zur Erläuterung der Funktionsweise der Schaltung nach Figur 4.

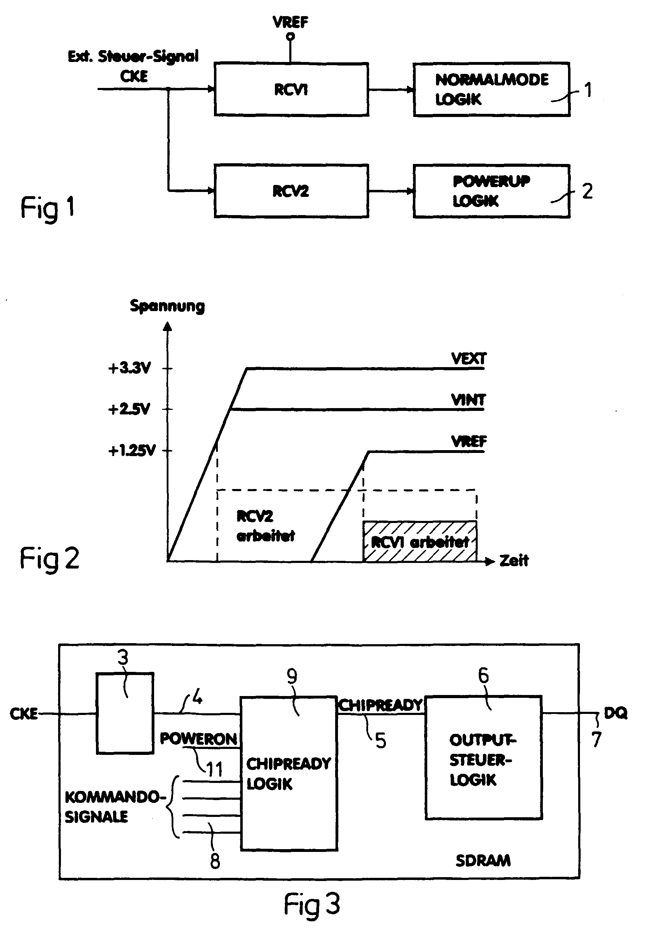

Figur 1 zeigt zunächst einige Bestandteile einer den Einschaltvorgang einer nach dem JEDEC-Standard arbeitenden SDRAM-Speichervorrichtung und ihrer Schaltungsbestandteile steuernden Initialisierungsschaltung mit einer regulären Empfängerschaltung RCV1, die mit einer internen oder auch externen Referenzspannung VREF arbeitet und mit der regulären Versorgungsspannung gespeist ist, einer der Schaltung RCV1 nachgeschalteten Normalmodelogik-Schaltung 1, sowie einer neben der Schaltung RCV1 zusätzlich vorgesehenen, separaten Vorausdetektorschaltung RCV2 und einer dieser nachgeschalteten POWERUP-Logik-Schaltung 2. Das von außen an die Halbleiter-Speichervorrichtung anliegende Takt-Steuersignal CKE = CLOCK-ENABLE-Signal wird sowohl der Schaltung RCV1 als auch der Schaltung RCV2 eingangsseitig zugeführt. Bei den vorbekannten dynamischen Halbleiter-Speichervorrichtungen wird das externe CKE-Signal nur von der Empfängerschaltung RCV1 detektiert und in die normale Logik weitergeleitet. Diese Empfängerschaltung RCV1 arbeitet mit einer Referenzspannung VREF, die normalerweise erst nach Abschluss des Einschaltvorganges stabilisiert ist. Aus diesem Grunde ist nicht definiert, zu welchem Zeitpunkt der POWERUP-Phase die Empfängerschaltung RCV1 stabil arbeitet. Um dennoch ein von außen angelegtes Takt-Steuersignal CKE so früh wie möglich stabil zu erkennen, ist nach der Erfindung die zusätzliche Empfänger-schaltung RCV2 vorgesehen, die ohne eine Referenzspannung auskommt und mithin nicht geeignet ist, das externe Signal grundsätzlich, d.h. während der normalen Betriebsweise des DRAM-Speichers zu detektieren. Die Schaltung RCV2 ist aber geeignet, das CKE-Signal zu Beginn der POWERUP-Phase zu detektieren, nachdem die interne Versorgungsspannung VINT einen bestimmten Wert erreicht hat. Diese zusätzliche Empfängerschaltung RCV2 ist damit in der Lage, ein definiertes CKE-Signal zu erfassen, noch bevor die Referenz-spannung VREF stabil ist.

Die Funktionsweise der in Figur 1 schematisch dargestellten Schaltung ergibt sich nach Figur 2. Man erkennt, dass die Empfängerschaltung RCV2 lange vorher arbeitet, bevor die reguläre Empfängerschaltung RCV1 nach einer Stabilisierung der Referenzspannung VREF auf einen Wert von etwa + 1.25 V tätig wird.

Die interne Versorgungsspannung VINT beträgt etwa + 2.5 V, die externe Versorgungsspannung VEXT etwa + 3.3 V. Die zeitliche Dauer vom Beginn der Funktionsfähigkeit der Empfängerschaltung RCV2 bis zum Arbeitseinsatz der regulären Empfängerschaltung RCV1 beträgt typischerweise einige µs.

Die reguläre Empfängerschalung RCV1 kann von Vorteil eine Differenzverstärkerschaltung darstellen, die dem Fachmann geläufig ist und daher nicht näher erläutert werden muss. Die Hilfsempfängerschaltung RCV2 kann von Vorteil eine schaltungstechnisch vergleichsweise einfache Inverterschaltung sein, die ohne Referenzspannung arbeitet und mit einer im Vergleich zur regulären Versorgungsspannung VINT geringeren Hilfsversorgungsspannung funktioniert.

Figur 3 zeigt weitere Einzelheiten der den Einschaltvorgang der Halbleiterspeichervorrichtung und ihrer Schaltungsbestandteile steuernden Initialisierungsschaltung mit einem RCV-Schaltblock 3, der unter anderem die in Figur 1 dargestellten Schaltungen RCV1, RCV2, 1 und 2 umfasst, einer Freigabeschaltung 9, an deren Eingang 8 die von außen an den Halbleiterspeicher einzugebenden Kommandosignale nach einer vermittels einem (nicht näher dargestellten) Kommandodecoder erfolgten Verstärkung und Aufbereitung anliegen, wobei unter anderem die Kommandosignale PRE bzw. PRECHARGE (Vorbereitungskommando für die Wortleitungsaktivierung), ARF bzw. AUTOREFRESH (Auffrischungskommando) und MRS bzw. MODE-REGISTER-SET (Lade-Konfiguration-Register-Kommando) am Eingang 8 der Freigabeschaltung 9 anliegen. Nicht näher dargestellt ist die an sich bekannte Regulierungs-Schaltung für die interne Spannungsregulierung bzw. -detektierung, an deren Eingang die von außen an den Halbleiter-Speicher anliegenden externen Versorgungsspannungen zugeführt sind, und an deren einem Ausgang das POWERON-Signal und an deren anderem Ausgang die stabilisierten internen Versorgungsspannungen geliefert werden. Wichtig für das Verständnis der Erfindung ist, dass diese Regulierungs-Schaltung ein aktives POWERON-Signal liefert, wenn nach der POWERUP-Phase des SDRAM-Speichers die am einen Ausgang der Regulierungs-Schaltung anliegenden internen Versorgungsspannungen die für den ordnungsgemäßen Betrieb des Bauelementes erforderlichen Werte erreicht haben.

Nach der erfindungsgemässen Ausführungsform gemäß Figur 3 besitzt die Initialisierungsschaltung darüber hinaus eine der Regulierungs-Schaltung und der RCV-Schaltung 3 nachgeschaltete Freigabeschaltung 9, an deren Eingang 8 unter anderem die Kommandosignale PRE, ARF und MRS, an deren Eingang 11 das POWERON-Signal von der Regulierungs-Schaltung, an deren Eingang 4 das aus dem externen Taktsteuersignal CKE wie vorstehend beschrieben abgeleitete erste Freigabesignal anliegt, und an deren Ausgang 5 das nach dem Erkennen einer vorbestimmten ordnungsgemäßen Initialisierungsabfolge der an die Halbleiter-Speichervorrichtung angelegten Kommandosignale das zweite Freigabesignal CHIPREADY geliefert wird, welches die Entriegelung der zum ordnungsgemäßen Betrieb der Halbleiter-Speichervorrichtung vorgesehenen Steuerschaltung 6 bewirkt. Diese interne Steuerschaltung 6 dient unter anderem der Ablaufsteuerung für einen oder mehrere der (nicht näher dargestellten) Speicherblöcke des SDRAM-Speichers und sind als solche bekannt. Der Ausgang 7 der Steuerschaltung 6 geht an die Datenleitungen DQ des SDRAM-Bausteins.

Die Funktionsweise der in Figur 3 dargestellten Schaltung ist wie folgt. Das extern an die Halbleiter-Speichervorrichtung zugeführte Takt-Steuersignal CKE wird von dem RCV-Schaltungsblock detektiert und an den Eingang 4 der Freigabeschaltung 9 weitergeleitet. In der Freigabeschaltung 9 werden die am Eingang 8 anliegenden Kommandosignale solange ignoriert, bis das externe Takt-Steuersignal CKE auf einen Spannungspegel logisch HIGH wechselt. Befindet sich das Taktsteuersignal CKE auf dem Spannungspegel logisch HIGH, so werden die Kommandosignale im Hinblick auf eine ordnungsgemäße Initialisierungsabfolge abgefragt. Sobald eine ordnungsgemäße Initialisierungsabfolge detektiert wird, wechselt das zweite Freigabesignal CHIPREADY auf den Spannungspegel logisch HIGH und als Folge hiervon werden die Ausgangstreiber freigegeben.

Die möglichen Signalzustände ergeben sich hierbei anhand nachfolgender Übersichtstabelle:

| **CKE** | **POWERON** | **Initialisierungsabfolge** | **CHIPREADY** | **DQ** |
|---|---|---|---|---|
| 0 | 0 | Nein | 0 | Z (= tristate) |
| 0 | 0 | Ja | 0 | Z |
| 0 | 1 | Nein | 0 | Z |
| 0 | 1 | Ja | 0 | Z |
| 1 | 0 | Nein | 0 | Z |
| 1 | 0 | Ja | 0 | Z |
| 1 | 1 | Nein | 0 | Z |
| 1 | 1 | Ja | 1 | Z oder aktiv |

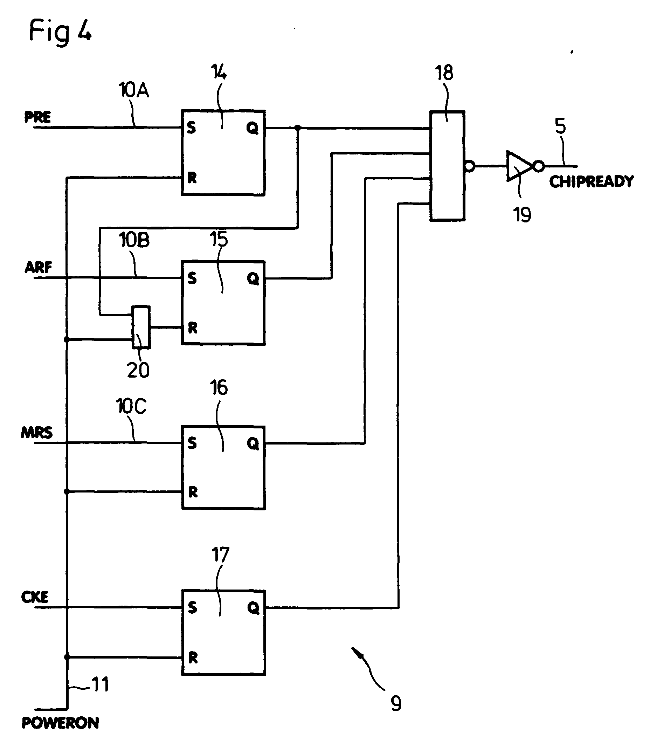

Figur 4 zeigt ein bevorzugtes Ausführungsbeispiel der Freigabeschaltung 9 nach der Erfindung. Diese umfasst vier bistabile Kippschaltungsstufen 14, 15, 16 und 17 mit jeweils einem Setzeingang S, einem Rücksetzeingang R, sowie einem Ausgang Q, ein dem Rücksetzeingang R der Kippschaltungsstufe 15 vorgeschaltetes UND-Gatter 20, ein sämtlichen Ausgängen Q der Kippschaltungsstufen 14, 15, 16, 17 nachgeschaltetes NAND-Gatter 18, sowie einem dem NAND-Gatter 18 nachgeschalteten Inverter 19, an dessen Ausgang 5 das Freigabesignal CHIPREADY ausgegeben wird, wobei das Freigabesignal HIGH-aktiv ist, d.h. aktiviert ist, wenn sein Spannungspegel auf logisch HIGH ist. Die an den jeweiligen Setzeingängen S der bistabilen Kippschaltungsstufen 14, 15, 16 anliegenden Kommandosignale PRE, ARF, MRS sind jeweils LOW-aktiv, d.h. diese Signale sind aktiv, wenn ihr Spannungspegel auf logisch LOW liegt, während das POWERON-Signal wiederum HIGH-aktiv ist. An dem Setzeingang S der bistabilen Kippschaltungsstufe 17 liegt das Takt-Steuersignal CKE oder ein hiervon unmittelbar abgeleitetes Signal an, der Ausgang Q der Kippschaltungsstufe 17 ist wiederum an einen Eingang des NAND-Gatters 18 angelegt. Das POWERON-Signal liegt bei den Kippschaltungsstufen 14 und 16 unmittelbar an den Rücksetzeingängen R an und liegt bei der Kippschaltungsstufe 15 zunächst an dem einen Eingang des UND-Gatters 20 an, an dessen anderem Eingang das von dem Ausgang Q der Kippschaltungsstufe 14 ausgegebenen Signal anliegt, wobei der Ausgang des UND-Gatters 20 mit dem Rücksetzeingang der Kippschaltungsstufe 15 verbunden ist.

Die Funktionsweise der in Figur 4 dargestellten Freigabeschaltung 9 ist dergestalt, dass eine Aktivierung des Freigabesignales CHIPREADY am Ausgang 5 auf logisch HIGH erst dann generiert wird, wenn eine vorbestimmte zeitliche Initialisierungsabfolge der Kommandosignale PRE, ARF und MRS und eine Aktivierung des POWERON-Signales auf den logischen Pegel HIGH detektiert wird. Erst danach werden aufgrund der Aktivierung des Freigabesignales CHIPREADY die Steuerschaltungen entriegelt; vorher bleiben diese Schaltungen verriegelt.

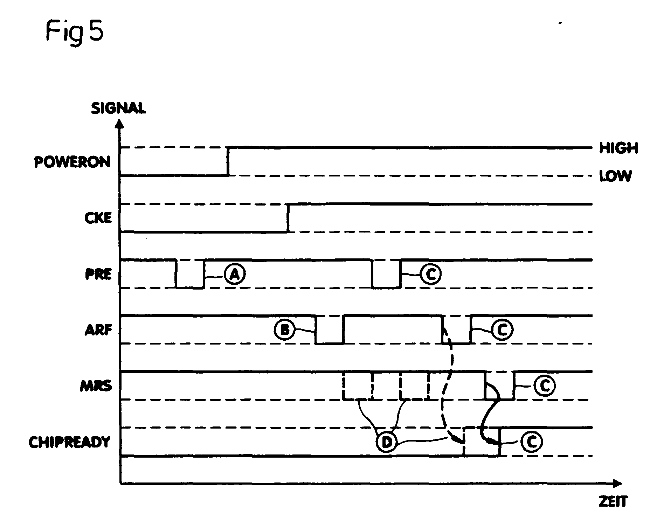

In dem schematischen Zeitablaufdiagramm nach Figur 5 sind beispielhafte Kommandoabfolgen während des Einschaltvorganges der Halbleiter-Speichervorrichtung zur Erläuterung der Funktionsweise der Freigabeschaltung 9 dargestellt.

Bei der Fallkonstellation A erfolgt eine gegenüber der Aktivierung des POWERON-Signales zu frühe Aktivierung des Signales PRECHARGE auf LOW-aktiv, so dass konsequenterweise noch keine Aktivierung des Freigabesignales CHIPREADY auf logisch LOW erfolgt, da die ordnungsgemäße Initialisierungsabfolge eine Wartezeit vor dem ersten Kommando erfordert. Richtigerweise wird damit der Signalhub des Kommandos PRECHARGE nach der Fallkonstellation A ignoriert. Bei der Fallkonstellation B ist die zeitliche Reihenfolge der Aktivierung des Signales AUTOFRESH auf logisch LOW falsch, da die ordnungsgemäße Initialisierungsabfolge einen vorherigen PRECHARGE-Befehl vor dem AUTOREFRESH-Befehl vorschreibt. Der Signalhub des AUTOREFRESH-Signales auf logisch LOW nach der Fallkonstellation B wird daher ebenfalls ignoriert, das Freigabesignal geht nicht auf logisch HIGH. Bei der Fallkonstellation C liegt - konform mit dem JEDEC-Standard - eine richtige zeitliche Reihenfolge der Befehle PRECHARGE, AUTOREFRESH, MODE-REGISTER-SET vor; folgerichtig wird nun, nachdem auch das POWERON-Signal auf logisch HIGH ist, ein Freigabesignal CHIPREADY auf logisch HIGH geliefert. Mit dem Symbol D ist strichliert dargestellt noch eine weitere denkbare, erlaubte und daher ein Freigabesignal auslösende Initialisierungsabfolge dargestellt: Eine Aktivierung des Kommandos MODE-REGISTER-SET auf logisch LOW ist nach der Aktivierung des POWERON-Signales jederzeit erlaubt.

Wegen weiterer Einzelheiten zur Funktionsweise und Anordnung der Freigabeschaltung 9 wird vollinhaltlich auf die am selben Anmeldetag eingereichte Patentanmeldung derselben Anmelderin mit dem Titel "Dynamische Halbleiter-Speichervorrichtung vom wahlweisen Zugriffstyp" und dem Anmelderaktenzeichen GR 96 E 1796 verwiesen und Bezug genommen.

## Patentansprüche

1. Dynamische Halbleiter-Speichervorrichtung vom wahlweisen Zugriffstyp (DRAM/SDRAM) mit einer den Einschaltvorgang der Halbleiter-Speichervorrichtung und ihrer Schaltungsbestandteile steuernden Initialisierungsschaltung, welche nach einer nach dem Einschalten der Halbleiter-Speichervorrichtung erfolgten Stabilisierung der Versorgungsspannung ein Versorgungsspannungsstabilsignal (POWERON) liefert,
dadurch **gekennzeichnet,**
dass die Initialisierungsschaltung eine Vorausdetektorschaltung (RCV2) aufweist, die einen vorbestimmten Pegelzustand eines von außen anliegenden Takt-Steuersignales (CKE) zeitlich vor dem Versorgungsspannungsstabilsignal (POWERON) erfasst und als Reaktion hierauf ein erstes Freigabesignal zur Entriegelung der zum ordnungsgemäßen Betrieb der Halbleiter-Speichervorrichtung vorgesehenen Steuerschaltung (6) liefert.

2. Halbleiter-Speichervorrichtung nach Anspruch 1,
dadurch **gekennzeichnet,**
dass die Vorausdetektorschaltung (RCV2) unabhängig von einer Referenzspannung arbeitet.

3. Halbleiter-Speichervorrichtung nach Anspruch 1 oder 2,
dadurch **gekennzeichnet,**
dass das von außen anliegende Takt-Steuersignal das CLOCK-ENABLE-Signal (CKE) darstellt.

4. Halbleiter-Speichervorrichtung nach einem der Ansprüche 1 bis 3,
dadurch **gekennzeichnet,**
dass die Vorausdetektorschaltung (RCV2) durch eine neben einer ohnehin in der Initialisierungsschaltung vorgesehenen regulären Empfängerschaltung separate, zusätzliche Hilfsempfängerschaltung ausgebildet ist, welche bei einer im Vergleich zur regulären Versorgungsspannung geringeren Versorgungsspannung arbeitet.

5. Halbleiter-Speichervorrichtung nach einem der Ansprüche 1 bis 4,
dadurch **gekennzeichnet,**
dass die Vorausdetektorschaltung (RCV2) während des Einschaltvorganges zur Halbleiter-Speichervorrichtung zunächst permanent eingeschaltet bleibt und erst dann abgeschaltet wird, sobald der vorbestimmte Pegelzustand des Takt-Steuersignales erfasst wurde.

6. Halbleiter-Speichervorrichtung nach einem der Ansprüche 4 bis 5,
dadurch **gekennzeichnet,**
dass die reguläre Empfängerschaltung eine Differenzverstärkerschaltung, und die Hilfsempfängerschaltung eine Inverterschaltung ist.

7. Halbleiter-Speichervorrichtung nach einem der Ansprüche 1 bis 6,
dadurch **gekennzeichnet,**
dass die Initialisierungsschaltung eine dem Versorgungsspannungsstabilsignal (POWERON) und weiteren, an die Halbleiter-Speichervorrichtung angelegten Kommandosignalen (PRE, ARF, MRS) zugeordnete Freigabeschaltung (9) aufweist, welche nach dem Erkennen einer vorbestimmten ordnungsgemäßen Initialisierungsabfolge der an die Halbleiter-Speichervor-richtung angelegten Kommandosignale (PRE, ARF, MRS) ein zweites Freigabesignal (CHIPREADY) liefert, welches die Entriegelung der zum ordnungsgemäßen Betrieb der Halbleiter-Speichervorrichtung vorgesehenen Steuerschaltung bewirkt.

8. Halbleiter-Speichervorrichtung nach Anspruch 7,
dadurch **gekennzeichnet,**
dass das zweite Freigabesignal (CHIPREADY) erst mit dem erstmaligen Pegelwechsel des von der Vorausdetektorschaltung (RCV2) erfassten Takt-Signales (CKE) entriegelt wird.

9. Halbleiter-Speichervorrichtung nach einem der Ansprüche 7 oder 8,
dadurch **gekennzeichnet,**
dass die von außen an die Halbleiter-Speichervorrichtung angelegten Kommandosignale (PRE, ARF, MRS) der von der Freigabeschaltung erkennenden Initialisierungsabfolge das Vorbereitungskommando für die Wortleitungsaktivierung (PRE-CHARGE), und/oder das Auffrischungskommando (AUTOREFRESH), und/oder das Lade-Konfigurations-Register-Kommando (MODE-REGISTER-SET) aufweist.

10. Halbleiter-Speichervorrichtung nach einem der Ansprüche 7 bis 9,
dadurch **gekennzeichnet,**
die Freigabeschaltung (9) wenigstens eine bistabile Kippschaltungsstufe (14, 15, 16) mit einem Setzeingang (S), an dem ein Kommandosignal (PRECHARGE, AUTOREFRESH, MODE-REGISTER-SET) anliegt, einem Rücksetzeingang (R), an dem das Versorgungsspannungsstabilsignal (POWERON) oder ein davon abgeleitetes bzw. verknüpftes Signal anliegt, und mit einem Ausgang (Q), an dem das zweite Freigabesignal (CHIPREADY) abgeleitet ist, aufweist.

11. Halbleiter-Speichervorrichtung nach einem der Ansprüche 7 bis 10,
dadurch **gekennzeichnet,**
dass die von der Freigabeschaltung (9) als ordnungsgemäße Initialisierungsabfolge erkannte und das zweite Freigabesignal (CHIPREADY) auslösende Initialisierungsabfolge eine mit dem JEDEC-Standard konforme Kommandofolge darstellt.

12. Halbleiter-Speichervorrichtung nach einem der Ansprüche 7 bis 11,
dadurch **gekennzeichnet,**
dass die Ausgangstreiber der Halbleiter-Speichervorrichtung beim Einschaltvorgang bis zur Ausgabe des von der Freigabeschaltung gelieferten zweiten Freigabesignals (CHIPREADY) verriegelt bleiben.

13. Halbleiter-Speichervorrichtung nach einem der Ansprüche 7 bis 12,
dadurch **gekennzeichnet,**
dass eine ordnungsgemäße Initialisierungsabfolge, welche die Auslösung des zweiten Freigabesignals (CHIPREADY) bewirkt, folgende zeitlich aufeinanderfolgende Kommandosequenzen umfasst:
a) erstens PRE, zweitens ARF, drittens MRS, oder
b) erstens PRE, zweitens MRS, drittens ARF, oder
c) erstens MRS, zweitens PRE, oder drittens ARF,
wobei die Abkürzungen folgende Kommandos bezeichnen:
PRE = Vorbereitungskommando für die Wortleitungsaktivierung (PRECHARGE),
ARF = Auffrischungskommando (AUTOREFRESH), und
MRS = Lade-Konfigurations-Register-Kommando (MODE-REGISTER-SET).

14. Halbleiter-Speichervorrichtung nach einem der Ansprüche 1 bis 13,
dadurch **gekennzeichnet,**
dass die reguläre Empfängerschaltung in SSTL-Logik (STUB-SERIES-TERMINATED-LOGIC) und die Hilfsempfängerschaltung in LVTTL-Logik (Low Voltage Transistor Transistor-Logik) aufgebaut sind.

15. Verfahren zur Detektion eines von außen anliegenden Steuersignales bei einer monolithisch integrierten dynamischen Halbleiter-Speichervorrichtung vom wahlweisen Zugriffstyp (DRAM/SDRAM) während des Einschaltvorganges (POWERUP) der Halbleiter-Speichervorrichtung,
**gekennzeichnet** durch
die Verwendung einer neben der regulären Empfängerschaltung zusätzlich vorgesehenen Hilfsempfängerschaltung, welche bei einer im Vergleich zur regulären Versorgungsspannung geringeren Versorgungsspannung arbeitet.

16. Verfahren zur Initialisierung einer dynamischen Halbleiter-Speichervorrichtung vom wahlweisen Zugriffstyp (DRAM/SDRAM) vermittels einer den Einschaltvorgang der Halbleiter-Speichervorrichtung und ihrer Schaltungsbestandteile steuernden Initialisierungsschaltung, welche nach einer nach dem Einschalten der Halbleiter-Speichervorrichtung erfolgten Stabilisierung der Versorgungsspannung ein Versorgungsspannungsstabilsignal (POWERON) liefert,
dadurch **gekennzeichnet,**
dass die Initialisierungsschaltung eine Vorausdetektorschaltung (RCV2) aufweist, die einen vorbestimmten Pegelzustand eines von außen anliegenden Takt-Steuersignales (CKE) zeitlich vor dem Versorgungsspannungsstabilsignal (POWERON) erfasst und als Reaktion hierauf ein erstes Freigabesignal zur Entriegelung der zum ordnungsgemäßen Betrieb der Halbleiter-Speichervorrichtung vorgesehenen Steuerschaltung liefert.

17. Verfahren nach Anspruch 16,
dadurch **gekennzeichnet,**
dass die Initialisierungsschaltung vermittels einer dem Versorgungsspannungsstabilsignal (POWERON) und weiteren, von außen an die Halbleiter-Speichervorrichtung angelegten Kommandosignalen (PRE, ARF, MRS) zugeordneten Freigabeschaltung (9) nach dem Erkennen einer vorbestimmten ordnungsgemäßen Initialisierungsabfolge der an die Halbleiter-Speichervorrichtung angelegten Kommandosignale ein zweites Freigabesignal (CHIPREADY) liefert, welches die Entriegelung der zum ordnungsgemäßen Betrieb der Halbleiter-Speichervorrichtung vorgesehenen Steuerschaltung (13) bewirkt.

18. Verfahren nach Anspruch 17,
dadurch **gekennzeichnet,**
dass die von außen an die Halbleiter-Speichervorrichtung angelegten Kommandosignale (PRE, ARF, MRS) der von der Freigabeschaltung (9) erkennenden Initialisierungsabfolge das Vorbereitungskommando für die Wortleitungsaktivierung (PRECHARGE), und/oder das Auffrischungskommando (AUTOREFRESH), und/oder das Lade-Konfigurations-Register-Kommando (MODE-REGISTER-SET) aufweist.

19. Verfahren nach Anspruch 17 oder 18,
dadurch **gekennzeichnet,**
dass die Ausgangstreiber der Halbleiter-Speichervorrichtung beim Einschaltvorgang bis zur Ausgabe des von der Freigabeschaltung (9) gelieferten zweiten Freigabesignals (CHIPREADY) verriegelt bleiben.

20. Verwendung einer ein zweites Freigabesignal (CHIPREADY) liefernden Freigabeschaltung (9) zur Steuerung des Einschaltvorganges einer dynamischen Halbleiter-Speichervorrichtung vom wahlweisen Zugriffstyp (DRAM/SDRAM) nach einem der Ansprüche 7 bis 14.
